# EUROPÄISCHE PATENTSCHRIFT

(11) **EP 4 103 766 B1**
(45) Veröffentlichungstag und Bekanntmachung des Hinweises auf die Patenterteilung: **29.04.2026**
(21) Anmeldenummer: 21705870.0
(22) Anmeldetag: 03.02.2021
(51) Int. Cl.: C25F 3/12, C25D 3/12, C25D 3/38, C25D 7/12, H01M 4/1395, H01M 4/134, H01M 4/04, H01M 4/66, H01M 10/0525, H01M 10/054, H01M 4/02, H01M 4/38, H01M 4/62

(54) **VERFAHREN ZUR HERSTELLUNG EINER ZYKLENSTABILEN SILIZIUM-ANODE FÜR SEKUNDÄRBATTERIEN SOWIE SILIZIUM-ANODE FÜR SEKUNDÄRBATTERIEN**
METHOD FOR PRODUCING A CYCLICALLY STABLE SILICON ANODE FOR SECONDARY BATTERIES, AND SILICON ANODE FOR SECONDARY BATTERIES
PROCÉDÉ DE PRODUCTION D'UNE ANODE EN SILICIUM À STABILITÉ CYCLIQUE POUR BATTERIES SECONDAIRES, ET ANODE EN SILICIUM POUR BATTERIES SECONDAIRES

(30) Priorität: 11.02.2020 DE 102020103469
(43) Veröffentlichungstag der Anmeldung: 21.12.2022
(73) Patentinhaber: Christian-Albrechts-Universität zu Kiel, 24118 Kiel (DE)
(72) Erfinder: ADELUNG, Rainer, 24147 Kiel (DE); HANSEN, Sandra, 24783 Osterrönfeld (DE); BAHR, Jörg, 24161 Altenholz-Klausdorf (DE); CARSTENSEN, Jürgen, 24146 Kiel (DE)
(86) Internationale Anmeldenummer: PCT/DE2021/100100
(87) Internationale Veröffentlichungsnummer: WO 2021/160212

(56) Entgegenhaltungen:
- DE-A1- 102009 056 530
- US-A1- 2016 118 643
- MUÑOZ-NOVAL ÁLVARO ET AL: "Accelerated growth from amorphous clusters to metallic nanoparticles observed in electrochemical deposition of platinum within nanopores of porous silicon", ELECTROCHEMISTRY COMMUNICATIONS, ELSEVIER AMSTERDAM, NL, vol. 71, 28 July 2016 (2016-07-28), pages 9 - 12, XP029723135, ISSN: 1388-2481, DOI: 10.1016/J.ELECOM.2016.07.013
- G. KOROTCENKOV ET AL: "Silicon Porosification: State of the Art", CRITICAL REVIEWS IN SOLID STATE AND MATERIALS SCIENCES, vol. 35, no. 3, 31 August 2010 (2010-08-31), US, pages 153 - 260, XP055710747, ISSN: 1040-8436, DOI: 10.1080/10408436.2010.495446

## Beschreibung

Die Erfindung betrifft ein Verfahren zur Herstellung von Silizium-Anoden für Sekundärbatterien - auch: Akkumulatoren -, insbesondere für Lithium-Ionen-Batterien, sowie eine mit dem Verfahren herstellbare Silizium-Anode.

Silizium-basierte Anoden sind bekannt als vorteilhaft in Lithium-Ionen-Batterien. Die Leistungsfähigkeit einer wiederaufladbaren Lithium-Ionen-Batterie wird gemessen in gespeicherter Energie pro Masse (Einheit: mAh/g). Eine entscheidende Größe ist dabei, wie viel Lithium in die beiden Elektroden - Anode und Kathode - pro Gramm Elektrodenmasse eingelagert werden kann. Weitere qualitätsbestimmende Faktoren für Sekundärbatterien, die wesentlich von den Elektroden abhängen, sind die Lagerbeständigkeit, d.h. die mögliche schadlose Liegedauer einer nicht belasteten Batterie, das Ausmaß der Selbstentladung, die Geschwindigkeit des Wiederaufladens und die Zyklenstabilität. Unter Zyklieren versteht man das wiederholte vollständige Be- und Entladen der Batterie (Ladezyklus), und eine zyklenstabile Batterie zeigt nur sehr geringen - idealerweise gar keinen - Kapazitätsverlust über eine große Anzahl von Ladezyklen.

Die Herstellungskosten, mithin also das Preis-Leistungsverhältnis, müssen bei aller technologischer Exzellenz bekannter Batteriekonzepte gleichwohl im marktfähigen Rahmen gehalten werden. Besonders für Akkumulatoren mit sehr hoher Speicherkapazität, etwa für die Bereiche Elektromobilität oder Hausenergiespeicher, bestehen hier noch Defizite, die einerseits mit Sicherheitserfordernissen und andererseits mit dem Herstellungsaufwand großflächiger und robuster Elektroden begründet sind.

Hinsichtlich Sicherheit sind Silizium-Batterieelektroden von Vorteil, weil sie den bisher verwendeten Kohlenstoff (Graphit-Elektroden) ersetzen könnten, was die Brandgefahr der Batterie deutlich verringert. Es ist seit langem bekannt, dass Silizium unter Bildung von Silizium-Lithium-Verbindungen ca. 11 mal mehr Lithium pro Gramm Silizium einlagern (interkalieren) kann als eine technisch gängige Graphitanode. Mit einer theoretischen Kapazität von über 4000 mAh/g liegt sie sogar noch über der von metallischem Lithium. Frühe Versuche zur Verwendung von Silizium-Anoden sind allerdings daran gescheitert, dass praktisch keine Zyklenstabilität erzielt worden war. Der Grund für die extrem schlechte Zyklenstabilität des Siliziums liegt in der mit der Lithium-Einlagerung verbundenen Volumenausdehnung des Siliziums auf das Vierfache. Die dabei auftretenden mechanischen Spannungen sind so groß, dass das Material dadurch pulverisiert wird.

Für die Anode einer Lithium-Ionen-Batterie schlägt die Arbeit von Chan et al. ("Highperformance lithium battery anodes using silicon nanowires", Nature Nanotechnology 3, 31 (2008)) vor, Silizium-Nanodrähte auf einem Metallfilm (charge collector) stehend anzuordnen. Die Arbeit von Chan et al. lässt Silizium-Nanodrähte mit bekannten Techniken (hier: Liquid-Vapour-Solid, LVS) auf z.B. einem Stahlsubstrat aufwachsen. Die Nanodrähte sind flexibel und können sich ohne zu brechen im Durchmesser verdoppeln. Die Nanostrukturierung des Siliziums vergrößert einerseits die Oberfläche zur Aufnahme von Lithium-Ionen und schafft andererseits Platz zur Vermeidung der genannten mechanischen Spannungen. Der Herstellungsprozess von Chan et al. ist aber umständlich und teuer. Das Aufwachsen der Silizium-Nanodrähte mit LVS-Verfahren erfordert Goldpartikel als Nukleationskeime, die an den Spitzen der Nanodrähte verbleiben. Die Nanodrähte selbst sind mit Gold gesättigt, was die Produktion dickerer Drähte oder auf größeren Flächen sehr kostspielig macht. Überdies sind die erhaltenen Nanodrähte nicht homogen. Es gibt dicke und dünne, lange und kurze, aufrecht stehende und gebogene, auf dem Substrat festsitzende und losgelöste Nanodrähte. Nicht mit dem Metallfilm kontaktierte Silizium-Nanodrähte sind bei der kommerziellen Herstellung besonders unerwünscht. Sie tragen nichts zur Kapazität der Batterie bei, absorbieren aber bei der ersten Beladung dennoch Lithium-Ionen, die nicht mehr extrahierbar sind (irreversible Kapazität). Und natürlich sind im Verfahren nach Chan et al. auch diese mit Gold gesättigt.

Die Druckschriften EP 2 460 214 B1 sowie US 2016/118643 A1 verfolgen das Ziel, das Ablösen der Silizium-Säulen von einem Metallfilm während des Zyklierens möglichst vollständig zu unterbinden, indem die Säulen im Bereich ihrer Fußpunkte Teilabschnitte aufweisen, die vom Metallfilm umschlossen sind, wobei der Metallfilm wenigsten ein Mikrometer dick ist. Die so eingebetteten Säulen aus monokristallinem Silizium werden vom Metallfilm - hier: aus Kupfer - festgehalten und auch daran gehindert, in den umschlossenen Teilabschnitten Lithium-Ionen aufzunehmen. Sie verbleiben beim Zyklieren fest verankert und damit in niederohmigem Kontakt mit dem metallischen Ableiter. Überdies sind in der EP 2 460 214 B1 alle Säulen gleich dick, gleich hoch, kristallographisch gleich orientiert und sogar regelmäßig angeordnet, was dem dort beschriebenen Herstellungsverfahren geschuldet ist. Die Nanosäulen ergeben sich als regelmäßiges Array auf einem Silizium-Wafer durch das gezielte Überätzen von Makroporen, wonach der Metallfilm galvanisch an den Füßen der stehenden Säulen abgeschieden und hiernach mit thermischer oder mechanischer Krafteinwirkung vom Wafer abgelöst wird. Die eingebetteten Silizium-Säulen verbleiben dabei im Metallfilm und werden vom Wafer abgerissen. Es ist herauszuheben, dass eine Silizium-Anode nach der EP 2 460 214 B1 auch nach Hunderten Ladezyklen keinen Kapazitätsverlust erkennen lässt. Das Herstellungsverfahren ist allerdings für die großflächige Herstellung kaum geeignet, u.a. weil sowohl die Ätzung - relativ tiefer - Makroporen als auch das Galvanisieren zeitaufwendig sind und überdies große Teile des teuren Wafermaterials nicht effizient genutzt werden können.

Muñoz-Noval Älvara et al. untersuchen in "Accelerated growth from amorphous clusters to metallic nanoparticles observed in electrochemical deposition of platinum within nanopores of porous silicon" (Electrochemistry Communications 71, 9-12 (2016), XP029723135, ISSN: 1388-2481, DOI: 10.1016/J.ELECOM.2016.07.013) die Bildung von amorphen Platinclustern (Pt) in Nanoporen aus porösem Silizium in einem Anfangsstadium der Porenfüllung. Die Zeitabhängigkeit des chemischen Zustands und der lokalen Struktur von Pt im nanoporösen Silizium wird durch Röntgenabsorptions-Feinstrukturspektroskopie (XAFS) charakterisiert. Zu Beginn weisen die Pt-Ablagerungen nicht vernachlässigbare Mengen an PtO2 auf, das durch Oberflächenoxidation aus der Atmosphäre gebildet wird, was darauf hindeutet, dass die Partikelgröße recht klein ist. Die eingehende Analyse der erweiterten XAFS (EXAFS) deutet stark darauf hin, dass das Pt in der frühen Phase der Abscheidung amorph ist. Der Mechanismus der amorphen Pt-Bildung wird auf der Grundlage des Einschließungseffekts für Pt-Komplexanionen in Nanoporen diskutiert.

Des Weiteren stellen G. Korotcenkov et al. in "Silicon Porosification: State of the Art" (Critical Reviews in Solid State and Material Sciences, 35 (3), 153-260 (2010), XP055710747, ISSN: 1040-8436, DOI: 10.1080/10408436.2010.495446) die Besonderheiten der Silizium-Porosifizierung und die Grundsätze der Herstellung poröser Schichten dar. Es werden verschiedene Methoden zur Porosierung von Silizium analysiert, wie z. B. chemisches Ätzen, chemisches Dampfätzen, laserinduziertes Ätzen, metallunterstütztes Ätzen, Funkenverarbeitung und reaktives Ionen-(Plasma-)Ätzen. Das Hauptaugenmerk wird jedoch auf die elektrochemische Porosierung von Si gerichtet. In der Druckschrift wird der Einfluss von Parametern wie Elektrolytzusammensetzung und pH-Wert, Stromdichte, Ätzzeit, Temperatur, Dotierung und Orientierung des Wafers, Beleuchtung, Magnetfeld und Ultraschallbewegung auf den Prozess der Si-Porosifizierung detailliert erörtert. Es wird gezeigt, dass die Struktur von porösem Silizium sowohl von den technologischen Parametern des elektrochemischen Ätzens als auch von den Parametern des zu behandelnden Halbleiters stark abhängt. Die Druckschrift befasst sich auch mit den wichtigsten Eigenschaften von porösem Silizium, der Bildung von porösen Mehrschichten und 3D-Strukturen, der Oxidation von porösem Silizium, der Freisetzung der porösen Schicht, dem Trocknen, der Lagerung, dem Ätzen, dem Füllen und der Oberflächenfunktionalisierung von porösem Silizium. Die Merkmale der Porosifizierung von III-V-Verbindungen werden ebenfalls kurz analysiert.

Auch ist aus der Druckschrift DE 10 2009 056530 A1 eine Struktur aus parallel zueinander verlaufenden, aus einem Halbleitermaterial gebildeten Nanodrähten mit wenigstens einer Flachseite mit freistehenden, regelmäßig angeordneten Nanodrahtenden, mit wenigstens einer makroporösen, aus demselben Halbleitermaterial gebildeten, von den Nanodrähten senkrecht durchdrungenen Stabilisierungsschicht, wobei die freistehenden Nanodrahtenden weniger als 100 µm über die Stabilsierungsschicht überstehen, bekannt.

Weitere Ansätze, Silizium-basierte Elektroden für Lithium-Ionen-Batterien zu schaffen, betreffen verschiedene Pulver aus Silizium-Kristalliten, beispielsweise Si-Bruchpartikel eines Wafers, vermischt mit elektrisch leitenden Partikeln, beispielsweise Carbon Black, die weiter mit einem organischen Binder gemischt als Dickschicht auf Metallbleche aufgebracht werden. Die isolierten Si-Partikel können Lithium interkalieren und dabei ihr Volumen vergrößern, ohne dass es zu erheblichen mechanischen Spannungen in den Schichten kommen muss, etwa weil die Matrix einer Schicht die mechanischen Kräfte ggf. durch Deformation aufnehmen kann. Gleichwohl bleiben die mechanischen Spannungen auf lange Sicht nicht folgenlos, sondern führen über die Zeit z.B. zur Unterbrechung der elektrischen Kontaktierung von Silizium mit der Ableitelektrode, ggf. sogar zum Ablösen der Beschichtung, und damit zum Kapazitätsverlust.

Die Druckschrift DE 10 2015 120 879 A1 schlägt als Silizium-Anode für Lithium-Ionen-Batterien vor, einen Kupferfilm mit Silizium zu beschichten, wobei das Silizium aus der Gas- oder Flüssigphase abgeschieden wird, und sodann mesoporöse Poren in das Silizium zu ätzen. Nach IUPAC-Definition sind mesoporöse Poren solche mit Porendurchmessern zwischen 2 und 50 nm. Die beabsichtigte Porosität (= Anteil Porenvolumen am Schichtvolumen) liegt bei 60 - 90 %, wodurch der Siliziumbeschichtung innerer Leerraum für die Volumenausdehnung unter Lithium-Beladung bereitgestellt werden soll. Da Silizium schlecht an Kupfer haftet, sieht die Arbeit einen zusätzlichen Haftvermittlerfilm enthaltend Titan, Nickel oder Vanadium, angeordnet zwischen dem Kupferfilm und dem abgeschiedenen Siliziumfilm, vor. Das Silizium wird während der Abscheidung p-dotiert, um die einseitige elektrochemische Ätzung von Mesoporen zu vereinfachen. Die Autoren diskutieren die Zyklenstabilität nur in Absatz 0048 der Druckschrift: "Im Vergleich zu den industriell etablierten kohlenstoffbasierten Materialien ist die Kapazität um den Faktor 4 erhöht, die Zyklenstabilität ist jedoch bisher noch geringer."Es ist anzumerken, dass sich Mesoporen auch in einen Silizium-Wafer mittels geeigneter Prozessparameter elektrochemisch ätzen lassen. Die Dotierung des Siliziums kann hilfreich sein, ist aber nicht entscheidend für das Erzeugen von Mesoporen in Si-Einkristallen. Insbesondere kann man durch Verändern der Ätzparameter während des Ätzvorgangs in verschiedenen Tiefen eines Wafers gezielt verschiedene Poren-Morphologien erzeugen. Dies ist eine komplexe, aber im Stand der Technik beherrschte Kunst.

Es ist die Aufgabe der Erfindung, ein kosteneffektives, großtechnisch anwendbares Verfahren zur Herstellung von zyklenstabilen Silizium-Anode für Sekundärbatterien vorzuschlagen.

Die Aufgabe wird gelöst durch ein Verfahren zur Herstellung einer Silizium-Anode für Sekundärbatterien gekennzeichnet durch die Schritte:
a. Bereitstellen eines monokristallinen Silizium-Wafers mit (100)-orientierten Flachseiten;
b. Kontaktieren der Rückseite des Wafers mit einer flächigen ersten Elektrode;
c. Einbringen der Vorderseite des Wafers in ein Ätzbad aufweisend einen Flußsäure-haltigen Elektrolyten und eine zweite Elektrode;
d. Elektrochemisches Ätzen von Mesoporen von wenigstens 4 Mikrometern Porentiefe in die Vorderseite des Silizium-Wafers durch Einrichten einer vorbestimmten Ätzstromdichte unter
e. Erzeugen einer Porosität zwischen 40 % und 80 % in der mesoporösen Schicht;
f. Erzeugen einer mikroporösen Ablöseschicht unterhalb der mesoporösen Schicht durch Erhöhen der Ätzstromdichte;
g. Verbringen des geätzten Wafers in ein Galvanisierungsbad;
h. Galvanisches Abscheiden eines Elementmetalls in die geätzten Mesoporen bis in eine vorbestimmte Porentiefe kleiner als 2 Mikrometer;
i. Abscheiden einer wenigstens einige Mikrometer dicken Metallschicht auf die geätzte Vorderseite des Wafers unter Erzeugen elektrisch leitender und mechanisch haftender Kontakte der Metallschicht mit dem Elementmetall in den Mesoporen;
j. Abheben der Metallschicht und der mesoporösen, in den Mesoporen teilweise mit Elementmetall befüllten, monokristallinen, (100)-orientierten Siliziumschicht unter mechanischem Zerstören der mikroporösen Ablöseschicht.

Außerdem umfasst die vorliegende Anmeldung eine Silizium-Anode gemäß Anspruch 8 und deren Verwendung gemäß Anspruch 9. Die Unteransprüche geben vorteilhafte Ausgestaltungen an.

Die Erfindung greift den Gedanken der DE 10 2015 120 879 A1 auf, mesoporöses Silizium für die Anode zu verwenden, um Platz für die Volumenexpansion im Zuge des Interkalierens insbesondere von Lithium-Ionen bereitzustellen. Allerdings wird der dortige Ansatz, einen Metallfilm mit Silizium zu beschichten hier durch das Gegenteil ersetzt, nämlich die Metallabscheidung auf einen monokristallinen, geätzten Silizium-Wafer. Es ist erfindungsgemäß wesentlich, dass das Silizium monokristallin ist und dass die beiden Flachseiten des Wafers (100)-orientiert sind, d.h. senkrecht zur (100)-Richtung des Volumenkristalls verlaufen.

Dazu ist anzumerken, dass das nach der DE 10 2015 120 879 A1 auf einem Metallfilm abgeschiedene Silizium alles andere als monokristallin ist. Die Druckschrift weist schon deshalb in eine völlig andere Richtung.

Entlang der (100)-Richtung ist ein besonders schnelles Wachstum des Siliziumkristalls möglich. Man kann deshalb davon ausgehen, dass eine (100)-orientierte Oberfläche eine stark ordnende Wirkung auf bewegliche Siliziumatome hat. Um diese aber ausnutzen zu können, darf die Kristallstruktur der Silizium-Anode trotz der während der Ladezyklen erheblichen Restrukturierungen des Siliziums nie ganz verloren gehen. Erfindungsgemäß wird die Kristallstruktur daher in einem Teil des mesoporösen Siliziums "eingefroren", indem bis in eine vorbestimmte Porentiefe ein Elementmetall galvanisch abgeschieden wird. Das abgeschiedene Elementmetall, vorzugsweise Kupfer oder Nickel, ist mechanisch fest und inkompressibel und nimmt dem Silizium bis zur Tiefe der Metallabscheidung jeglichen Platz zur Bewegung oder Volumenvergrößerung, so dass die Interkalation im mit Elementmetall befüllten Schichtbereich unterbunden ist. Damit bleiben Kristallinität und (100)-Orientierung des Siliziums in diesem Schichtbereich auch während der Ladezyklen einer Sekundärbatterie immer erhalten. Die nicht mit Elementmetall befüllten Anteile des mesoporöse Silizium werden durch die Aufnahme von Ionen zwar weitgehend restrukturiert, aber sie ordnen sich beim Entladen der Ionen wieder selbstorganisiert in einer Weise an, die ein gleichförmiges, vorhersagbares und zyklenstabiles Verhalten der Silizium-Anode bewirkt. Es wird davon ausgegangen, dass diese Selbstorganisation durch die Präsenz der monokristallinen (100)-Fläche überhaupt erst ermöglicht - zumindest aber sehr begünstigt - wird.

Ein Nebeneffekt der galvanischen Abscheidung von Elementmetall in die geätzten Mesoporen des Wafers und die anschließende Abscheidung eines Metallfilms auf dieselbe Flachseite des Wafers ist die robuste mechanische Kopplung zwischen Metallfilm und Silizium durch das Schlüssel-Schloss-Prinzip. Während die stoffschlüssige Haftung des Elementmetalls in den Poren an dem Metallfilm bekanntlich sehr gut ist, ist die Haftung von Silizium auf manchen Metallen, z.B. Kupfer, eher schlecht. Die mit Elementmetall befüllten Mesoporen sind jedoch gewöhnlich nicht glatt und kanalartig, sondern weisen mit der Porentiefe variierende Durchmesser und seitlich - d.h. senkrecht zum Porenverlauf - gerichtete Auswüchse oder Zackungen auf. Wenn solche Poren mit festem Material befüllt sind, kann das Material nicht herausgezogen werden; es ist vielmehr durch Formschluss mechanisch verankert. Dies macht ein Ablösen des mit Elementmetall befüllten Bereichs der Siliziumschicht vom Metallfilm nahezu unmöglich.

Die Erfindung wird im Folgenden auch anhand von Figuren näher erläutert. Dabei zeigen:
- Fig. 1: eine Skizze der Silizium-Anode entlang eines Schnittes senkrecht zum Wafer bzw. zum Metallfilm;
- Fig. 2: eine Rasterelektronenmikroskop (REM) Aufnahme des mesoporösen Si-Wafers;
- Fig. 3: gemessene spezifische Kapazitäten für die Si-Anode in einer Testzelle mit einem Lithium-Ionen enthaltenden Elektrolyten während der ersten 100 Ladezyklen;
- Fig. 4: a) und b) je eine REM-Aufnahme einer Si-Anode mit einer 6 Mikrometer dicken Siliziumschicht nach einigen Ladezyklen in der Lithium-Testzelle in zwei Vergrößerungen;
- Fig. 5: gemessene Ladekapazitäten für eine Si-Anode mit einer Schichtdicke von 26 µm gegenüber einer Nickel-Mangan-Cobalt-Kathode;
- Fig. 6: gemessene spezifische Kapazitäten für die Si-Anode in einer Testzelle mit einem Natrium-Ionen enthaltenden Elektrolyten während der ersten 17 Ladezyklen;
- Fig. 7: a) und b) REM-Aufnahmen der Si-Anode nach einigen Ladezyklen in der Natrium-Testzelle in zwei Vergrößerungen;
- Fig. 8: gemessene spezifische Kapazitäten für die Si-Anode in einer Testzelle mit einem Kalium-Ionen enthaltenden Elektrolyten während der ersten 15 Ladezyklen.

Ein monokristalliner Si-Wafer kann mit bekannten Methoden elektrochemisch geätzt werden, um verschiedenartige Poren im Silizium zu erzeugen. Dem Fachmann der Elektrochemie sind dabei die Verfahrensschritte a) bis f) an sich geläufig, und er weiß, wie er die genauen Ätzparameter (Stromdichte, Ätzdauer, Elektrolyttemperatur und -strömung) zu ermitteln hat, wenn er eine vorbestimmte Wafer-Charge mit vorbestimmter Dotierung mit einer Elektrolytzusammensetzung seiner Wahl mesoporös ätzen möchte. Lediglich beispielsweise kann er sich an der Druckschrift DE 103 18 995 B4 und den darin zitierten Quellen orientieren. Wie bereits erwähnt ist eine bestimmte Dotierung des Siliziums nicht zwingend erforderlich. Es ist allerdings für die Mesoporenätzung durchaus vorteilhaft, dotiertes Silizium zu verwenden. Solches ist allgemein auch preiswerter als hochreines Silizium. Im Experiment zeigt sich, dass ein - beispielsweise durch Bor - p-dotierter Silizium-Wafer, der einen spezifischen Widerstand von weniger als 10 mΩcm, bevorzugt um 8 mΩcm, aufweist, eine vorteilhafte Wahl darstellt.

Aus der Druckschrift US 7,208,069 B2 ist eine Ätzvorrichtung für große Siliziumwafer bekannt, die sich auch zum Erzeugen von Mesoporen eignet. Als Elektrolyt kommt beispielsweise eine wässrige Lösung enthaltend 20 wt% Fluorwasserstoff (HF) und 5 wt% Ethanol und 1 wt% Polyethylenglykol (PEG) in Betracht; ggf. kann zusätzlich oder anstelle von PEG auch 1 wt% Schwefelsäure (H₂SO₄) beigemengt werden. Die Badtemperatur beträgt üblich konstant 20 °C, und die Stromdichte kann in einem typischen Fenster zwischen 50 und 100 mA/cm² eingerichtet werden, wobei größere Werte zu größerer Porosität führen.

Erfindungsgemäß soll das Gesamtvolumen der Mesoporen zwischen 40 % und 80 % des ursprünglichen Siliziumvolumens in der mesoporös geätzten Schicht betragen. Der Grund für die Breite des Intervalls wird unten weiter erläutert. Speziell bei Si-Anoden für Lithium-Ionen-Batterien ist es vorteilhaft, die Porosität auf einen Wert zwischen 70 % und 75 % einzurichten.

Der Fachmann weiß auch - oder er kann durch Vorversuche leicht ermitteln - wie weit und für wie lange er in seinem Aufbau die Ätzstromdichte zu erhöhen hat, um eine mikroporöse Ablöseschicht mit einer schwammartigen Porenstruktur unter der mesoporösen Schicht zu erzeugen. Man kann die Ablöseschicht so auslegen, dass sie nur noch sehr dünne, spröde Porenwände aufweist, die sich mechanisch leicht brechen lassen. Solange die Porenwände noch intakt sind, bleibt die mesoporöse Schicht aber mit dem Wafer verbunden und kann mit diesem zusammen bewegt werden.

Erfindungsgemäß wird der geätzte Wafer hiernach in ein Galvanisierungbad verbracht, das einen Elektrolyten mit Elementmetall-Ionen enthält. Vorzugsweise kommen hierfür Kupfer- oder Nickel-Ionen in Frage.

Mögliche Elektrolyten sind beispielsweise wässrige Kupfer/Nickelsulfat Lösungen (mit einer Molarität von 0.25 M bis 1.25 M) mit Zusätzen von Schwefelsäure (H₂SO₄) und 1 wt.% PEG (M~3360) bevorzugt bei einem pH-Wert zwischen 1 und 2.7. Die besten Ergebnisse für die Nickel-Abscheidung werden mit Watts-Solution erzielt: 200 g/l Nickelsulfat (NiSO₄), 45 g/l Nickelchlorid (NiCl₂), 45 g/l Borsäure (H₃BO₃). Ebenfalls gute Ergebnisse lassen sich unter Zuhilfenahme von Nickelsulfamat Ni(SO₃NH₂) von 30 g/l erreichen, welches anstelle des NiSO₄ hinzugesetzt wird.

Der Elektrolyt dringt wenigstens in einem oberflächennahen Bereich auch in die Mesoporen ein, und die Mesoporen werden dann durch Bestromung und abscheidende Reduktion der Ionen teilweise mit Elementmetall befüllt. "Teilweise" bedeutet hier, dass nicht die gesamte Porentiefe - die wenigstens 4 Mikrometer betragen soll - mit Elementmetall ausgefüllt wird. Denn die Abscheidung in den Mesoporen wird in Porentiefen jenseits von einigen 100 Nanometern schwierig, weil der Elektrolytfluss zu sehr behindert wird. Für die Zwecke der Erfindung reicht die Metallabscheidung über eine Porentiefe zwischen einigen 10 und mehrere 100 Nanometer durchaus schon aus. Der Fachmann weiß, dass er die Eindringtiefe des Elektrolyten u. a. durch Kontrolle der Viskosität des Elektrolyten beeinflussen kann.

Vorzugsweise setzt man hiernach die Metallabscheidung solange fort, bis sich eine wenigstens einige Mikrometer dicke Metallschicht auf der Wafer-Oberfläche gebildet hat. Die Metallschicht und die Elementmetallabscheidungen in den Mesoporen werden stoffschlüssig verbunden, was den besten elektrisch leitfähigen und mechanisch haftenden Kontakt sicherstellt. Alternativ kann man die Metallschicht auch aus einem anderen Metall bilden als jenem, mit dem die Mesoporen befüllt worden sind. Beispielsweise kann man den Elektrolyten wechseln oder auch zu einem anderen Metallisierungsverfahren greifen, um die Metallschicht aufzubringen. Die Metallschicht muss am Ende der Herstellung in der Lage sein, den mit Mesoporen versehenen Silizium-Einkristall frei zu tragen, der nach dem Zerstören der besagten Ablöseschicht vom Wafer getrennt an der Metallschicht haftet.

Die Ablöseschicht ist sehr spröde und kann mechanisch zerstört werden, beispielsweise, indem man den fertigen Metallfilm und den mesoporösen Silizium-Einkristall vom Wafer abzieht. Eine andere Möglichkeit der mechanischen Zerstörung kann im Einstrahlen von ggf. gepulstem und/oder fokussiertem Ultraschall in die Ablöseschicht bestehen.

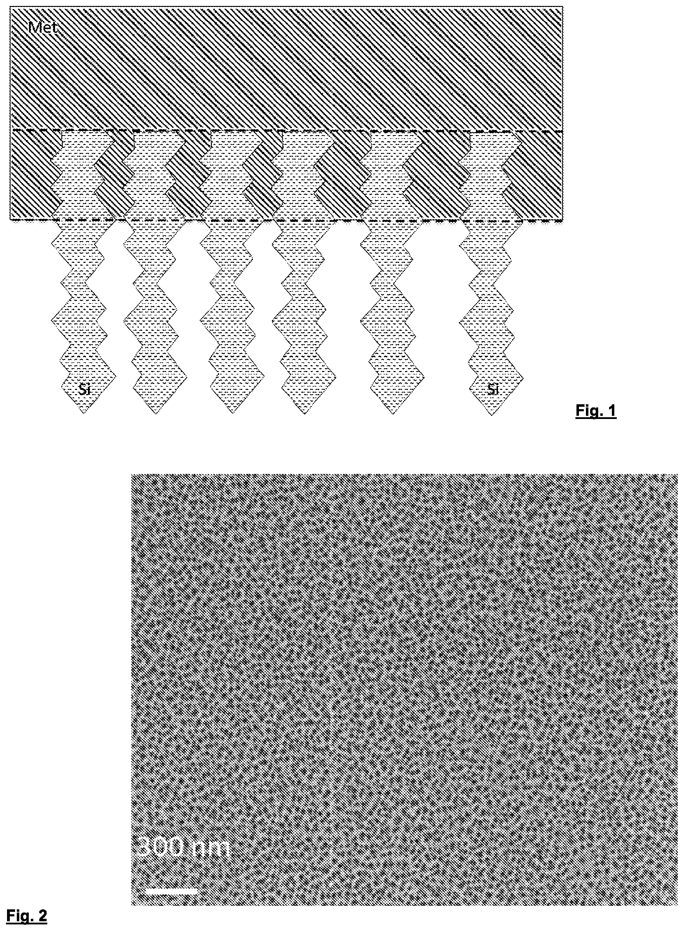

Das Resultat des Verfahrens ist in Fig. 1 skizziert. In dieser senkrecht zum Metallfilm (Met) und zum Si-Wafer gezeigten Schnittskizze sind die gezackt verlaufenden Mesoporenwände (Si) dargestellt und die Poren als Zwischenräume. Zwischen den gestrichelt gezeichneten Linien ist das Metall in den Poren abgeschieden; die Poren sind also teilweise befüllt. Im gezeigten Fall ist die galvanische Abscheidung eines Elementmetalls in den Poren fortgesetzt worden, bis ein wenigstens einige Mikrometer dicker Metallfilm entstanden ist, d.h. innerhalb und außerhalb der Poren ist das Metall dasselbe.

Die Dicke der am Metallfilm haftenden Siliziumschicht ist durch die Wahl der Mesoporentiefe beim Ätzprozess bestimmt und sollte erfindungsgemäß wenigsten 4 Mikrometer betragen. Bevorzugt ist die mesoporöse Siliziumschicht 4 bis 16 Mikrometer, besonders bevorzugt zwischen 6 und 12 Mikrometer dick. Die Ätzgeschwindigkeit beträgt in dem oben beschriebenen Ausführungsbeispiel etwas mehr als 2 Mikrometer pro Minute.

Auf den ersten Blick erinnert Fig. 1 an eine Skizze der vom Metall umschlossenen Si-Nanodrähte aus der Druckschrift EP 2 460 214 B1. Diese Assoziation wäre aber irreführend, denn das in Fig. 1 gezeichnete Si ist außerhalb der Bildebene vollständig miteinander verbunden. Tatsächlich umschließt hier vielmehr das Silizium Metallvorsprünge aus dem Metallfilm.

Die Fig. 1 skizziert die erfindungsgemäße Silizium-Anode für Sekundärbatterien umfassend eine Metallschicht und eine mesoporöse, in den Mesoporen teilweise mit Elementmetall befüllte, monokristalline, (100)-orientierte Siliziumschicht, wobei das Elementmetall in den Mesoporen in elektrisch leitendem und mechanisch haftendem Kontakt mit der Metallschicht steht. Die Anode kann unmittelbar mit elektrischen Zuleitungen am Metallfilm kontaktiert in eine Lithium-Sekundärbatterie eingesetzt werden, wobei als Kathode eine Elektrode aus metallischem Lithium dienen kann. Die Siliziumseite der Anode wird einem wasserfreien, Lithium-Ionen enthaltende Elektrolyten zugewandt angeordnet. Bei vollständig entfernter Ablöseschicht sieht die Siliziumseite genauso aus wie die mesoporös geätzte Vorderseite des Si-Wafers; diese ist als REM-Aufnahme in Fig. 2 zu sehen.

In der Sekundärbatterie eignen sich beispielsweise folgende zwei Elektrolyttypen:
a) ein Carbonat-basierter Elektrolyt. Dieser besteht aus 1 M Lithiumhexafluorophosphat (LiPF₆), welches in Lösungsmitteln Ethylencarbonat (EC) und Dimethylcarbonat (DMC) gelöst ist im Verhältnis von 1:1 (kommerziell erhältlich).
b) ein Ether-basierter Elektrolyt. Dieser kann als eine Lösung aus dem Salz Lithium bis(trifluoromethanesulfonyl)imide (LiTFSi) etwa in Dioxolan-1,3 (DOL) und Dimethylether (DME) im Verhältnis von 1:2 erzeugt werden.

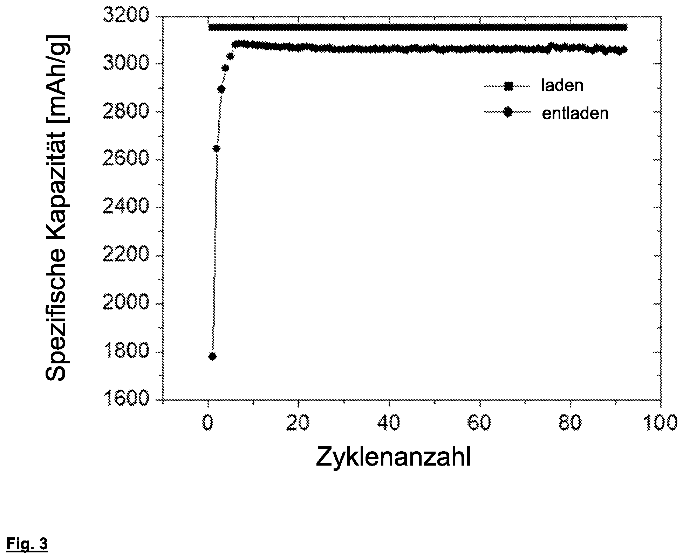

Fig. 3 zeigt gemessene spezifische Ladekapazitäten einer Lithium-Ionen-Testzelle umfassend eine Silizium-Anode mit einer 6 Mikrometer dicken Siliziumschicht sowie eine Lithiummetallkathode. Wie in der Batterietechnologie üblich, wird die Beladung mit Lithium nur bis zu etwa 75 % des theoretischen Maximums durchgeführt. Die Entladekurve zeigt, dass sich die verfügbare Ladekapazität schon nach wenigen Zyklen auf hohem Niveau stabilisiert. Ab etwa dem 20. Zyklus sind keine Änderungen mehr feststellbar. Das Laden und Entladen der Testzelle beansprucht in dem gezeigten Test jeweils zwei Stunden.

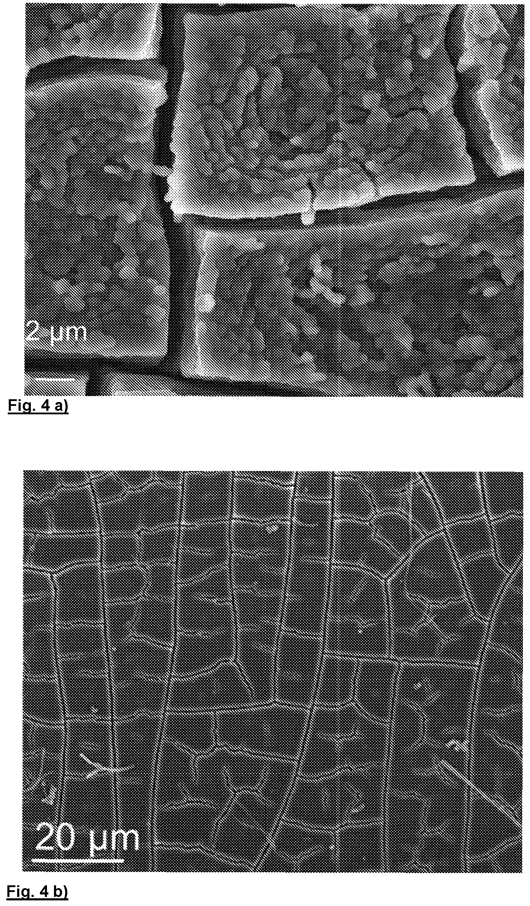

Die nach dem Zyklieren stabilisierte, entladene Anode kann ausgebaut und inspiziert werden. Unter dem Rasterelektronenmikroskop zeigt die Siliziumseite eine Restrukturierung wie dargestellt in den Fig. 4 a) und b) in zwei Vergrößerungen. Es haben sich über die ganze Fläche hinweg turmförmige Strukturen gebildet, die durch Risse voneinander separiert sind. Die Risse bilden dabei ein weitgehend zusammenhängendes Netzwerk und sind etwa 1 Mikrometer breit. Das Erscheinungsbild der Oberfläche ähnelt dem eines ausgetrockneten Flussbetts, in dem sich beim Verdunsten des Wassers in den Sedimenten Trocknungsrisse zeigen. Nähere Untersuchungen zeigen, dass die turmartigen Strukturen an ihrer Oberfläche mit einer festen, aus Silizium und Lithium gebildeten Mischkristallphase, die als "solid-electrolyte interface" (SEI) bezeichnet wird, überzogen sind. Von dieser SEI ist bekannt, dass sie sich während des Interkalierens von Lithium mit dem Volumen des Siliziums ausdehnt und beim Entladen wieder zusammenzieht (S Hansen, S Shree, G Neubüser, J Carstensen, L Kienle, R Adelung, "Corsetlike solid electrolyte interface for fast charging of silicon wire anodes", Journal of Power Sources 381, 8-17, 2018). Die SEI bleibt auch beim vollständigen Entladen der Batterie erhalten und bindet dauerhaft einen gewissen Anteil der Lithium-Ionen des Elektrolyten. Sie zerreißt nicht und wächst nicht dauerhaft an, so wie in herkömmlichen Lithium-Ionen-Batterien mit Graphit. Sie ummantelt perfekt diese Risse und gibt ihnen zusätzlichen mechanischen Halt und Stabilität.

Es ist hier wichtig festzuhalten, dass die in Fig. 4 gezeigte Struktur nicht wesentlich davon abhängt, nach wie vielen Ladezyklen man die Anode untersucht. Trotz der erheblichen Restrukturierung der Siliziumschicht während jedes einzelnen Ladezyklus bildet sich die beschriebene Flussbett-Struktur immer wieder neu aus. Hierin wird der Hauptgrund für die messbare Zyklenstabilität der neuen Silizium-Anode gesehen. Zugleich ist ihre Speicherkapazität auch den besten verfügbaren Carbon-basierten Anoden deutlich überlegen. Nach Abschätzung der Erfinder lässt eine serientaugliche Lithium-Ionen-Batterie mit der erfindungsgemäßen Anode und den besten heute kommerziell verfügbaren Kathoden mindestens eine Verdopplung der Ladekapazität solcher Batterien erwarten.

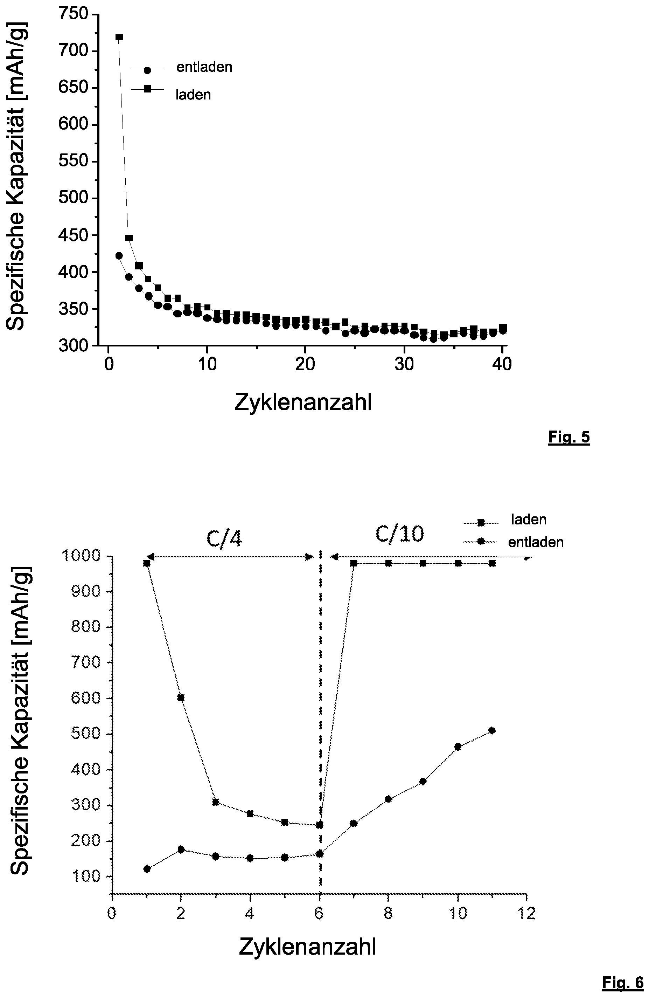

In Fig. 5 ist auch ein Plot gemessener Ladekapazitäten für eine erfindungsgemäße Silizium-Anode mit einer Siliziumschicht der Dicke 26 Mikrometer und einer Porosität von 65 % bei 30 Nanometer Porendurchmesser gegenüber einer Nickel-Mangan-Cobalt-Kathode gezeigt. Im Vergleich zur Fig. 3 ist das Kapazitätsniveau erheblich geringer, was vor allem der limitierten Kathode geschuldet ist, die nicht die volle Leistungsfähigkeit der Silizium-Anode ausschöpfen kann. Wichtiger ist jedoch hier die Stabilität der Anode über 40 Ladezyklen (Laderate C/4), wobei Be- und Entladekapazität in allen Zyklen oberhalb von 300 mAh/g liegen. Obwohl sich nach diesen Messwerten nur ein relativ kleiner Anteil der Siliziumschicht am Speichern des Lithiums aktiv beteiligt, ist die Verankerung der monokristallinen, (100)-orientierten, mesoporösen Siliziumschicht am Metallfilm notwendig. Ohne die galvanischen Abscheidungen in die Mesoporen zur Etablierung des Schlüssel-Schloss-Prinzips zerbröselt die 26 Mikrometer Schicht schon nach etwa 10 Ladezyklen und verliert dabei ihre elektrische Kontaktierung.

Aus den Untersuchungen für mehrere Dicken der Siliziumschicht ergibt sich, dass sich eine zyklenstabile Silizium-Anode für Sekundärbatterien mit Siliziumschichtdicken von wenigstens 4 Mikrometer realisieren lässt. Die Messungen zeigen weiter, dass Schichtdicken zwischen 4 und 16 Mikrometer, ganz besonders zwischen 6 und 12 Mikrometer, die derzeit besten Ergebnisse - besonders effiziente Speicherung von Lithium-Ionen - versprechen und deshalb bevorzugt sind.

Abschließend soll noch darauf hingewiesen werden, dass Silizium auch andere Alkalimetalle, vor allem Natrium und Kalium, interkalieren kann. Deshalb kann die Silizium-Anode auch in eine Testzelle mit einem Natrium- oder Kalium-Ionen-Elektrolyten und einer metallischen Natrium- oder Kalium-Kathode eingesetzt und zykliert werden. Dafür kommen beispielsweise die vorgenannten Ether-basierten Elektrolyten in Frage, in denen wahlweise die Salze Natrium trifluoromethanesulfonimide (NaTFSi) für Natrium-Batterien oder Kalium trifluoromethanesulfonimide (KTFSi) für Kalium-Batterien gelöst sind.

Tatsächlich erweist sich die erfindungsgemäße Silizium-Anode auch als tauglich zur Verwendung in Natrium- oder Kalium-Ionen-Batterien. Es lassen sich zumindest überraschend stabile Ladezyklen durchführen, die allerdings zum Teil noch längere Zeit als beim Lithium beanspruchen.

Weil aber Natrium oder Kalium beim Interkalieren des Siliziums eine geringere Volumenvergrößerung des Siliziums bewirken als Lithium, kann es zweckmäßig sein, die Silizium-Anode durch das Vorsehen einer kleineren Porosität, insbesondere auf einen Wert aus dem Intervall von 40 % bis 60 %, auf diesen Umstand auszulegen.

Beispielsweise ist in Fig. 6 ein Plot mit gemessenen Ladekapazitäten einer Natrium-Testzelle zu sehen. Das Beladen der Anode mit Natrium-Ionen erfolgt hier bis zur theoretisch maximalen Ladekapazität, die verschiedenen Quellen zufolge etwa bei 1000 mAh/g liegt. Die Messdaten umfassen 11 Ladezyklen, von denen die ersten 6 mit einer hohen Laderate von C/4 durchgeführt werden. Zu Beginn ist die Natrium-Kathode noch nicht passiviert, also mit einer Schutzschicht überzogen, was die anfangs hohe Kapazität beim Beladen erklärt. Sobald diese SEI auf der Natrium-Kathode und auf der Silizium-Anode gebildet worden ist, fällt die Beladekapazität dann sehr deutlich ab, während die Entladekapazität auf geringem Niveau verbleibt. Ab Zyklus 7 wird die Laderate nun aber deutlich verringert auf C/10, also auf 10 Stunden Ladezeit für eine vollständige Beladung. Dies hat den gut erkennbaren Effekt, dass sich beim Beladen die maximale Kapazität ausschöpfen lässt, während die Entladekapazität mit jedem weiteren Zyklus ansteigt - bis sich ein Endniveau einstellt, das hier noch nicht erreicht worden ist. Der Grund für das klar verbesserte Akku-Verhalten ist darin zu sehen, dass die Natrium-Ionen eine ausreichende Zeit benötigen ins Silizium zu interkalieren und die Aktivierungsenergie zu überbrücken. Es lässt sich also mit der Silizium-Anode tatsächlich auch eine Natrium-Ionen-Sekundärbatterie schaffen, die elektrische Ladung derzeit nur relativ langsam speichert und wieder abgibt. Aber der Vorteil, Natrium- statt Lithium-Ionen verwenden zu können, um beispielsweise Energie aus Photovoltaik-Zellen zu speichern, erscheint hier unbedingt erwähnenswert.

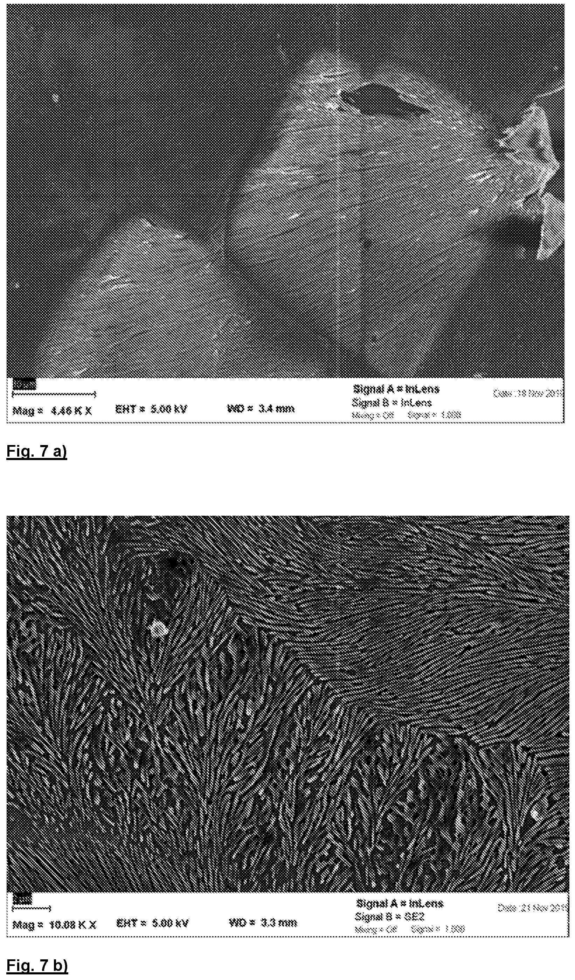

In Fig. 7 a) und b) sind REM-Bilder in zwei Vergrößerungen der in der Natrium-Testzelle zyklierten Silizium-Anode zu sehen. Zu sehen ist eine Siliziumoberfläche, die mit dünnen Lamellen benetzt ist. Aufgrund der verringerten Volumenausdehnung des Siliziums beim Sodiieren tritt allerdings - insbesondere sichtbar in Fig. 7 b) - ein wesentlich kleineres Rissmuster auf. Hervorzuheben ist die Beobachtung, dass sich das Rissmuster auch bei wiederholtem Zyklieren immer wieder so etabliert. Dies gibt den Anlass, eine hohe Zyklenstabilität der erfindungsgemäßen Silizium-Anode auch in einer Natrium-Ionen-Batterie zu erwarten.

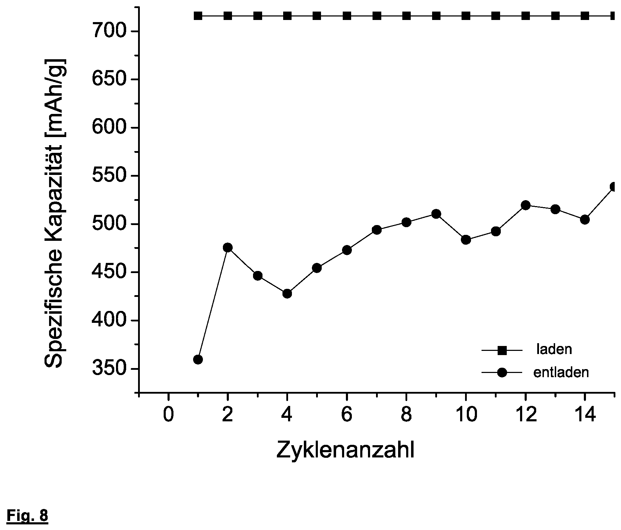

Fig. 8 zeigt einen Plot mit gemessenen Ladekapazitäten für eine Kalium-Ionen-Testzelle umfassend eine erfindungsgemäße Silizium-Anode und eine Kalium-Kathode. Zu sehen ist das Verhalten der Zelle während der ersten 15 Ladezyklen, wobei jede Be- und Entladung 4 Stunden beansprucht (Laderate C/4). Interessanterweise zeigen sich hier nicht die Anpassungsprobleme der Elektroden wie beim Natrium, und das Endniveau der entnehmbaren Ladekapazität ist gut abschätzbar und liegt bei ungefähr 550 mAh/g. Man beachte, dass die linke Skala erst bei 350 mAh/g beginnt. Das Verhältnis von Entladekapazität zu Beladekapazität beträgt also grob 75 %.

## Patentansprüche

1. Verfahren zur Herstellung einer Silizium-Anode für Sekundärbatterien **gekennzeichnet durch** die Schritte:
a. Bereitstellen eines monokristallinen Silizium-Wafers mit (100)-orientierten Flachseiten;
b. Kontaktieren der Rückseite des Wafers mit einer flächigen ersten Elektrode;
c. Einbringen der Vorderseite des Wafers in ein Ätzbad aufweisend einen Flußsäure-haltigen Elektrolyten und eine zweite Elektrode;
d. Elektrochemisches Ätzen von Mesoporen von wenigstens 4 Mikrometern Porentiefe in die Vorderseite des Silizium-Wafers durch Einrichten einer vorbestimmten Ätzstromdichte unter
e. Erzeugen einer Porosität zwischen 40 % und 80 % in der mesoporösen Schicht;
f. Erzeugen einer mikroporösen Ablöseschicht unterhalb der mesoporösen Schicht durch Erhöhen der Ätzstromdichte;
g. Verbringen des geätzten Wafers in ein Galvanisierungsbad;
h. Galvanisches Abscheiden eines Elementmetalls in die geätzten Mesoporen bis in eine vorbestimmte Porentiefe kleiner als 2 Mikrometer;
i. Abscheiden einer wenigstens einige Mikrometer dicken Metallschicht auf die geätzte Vorderseite des Wafers unter Erzeugen elektrisch leitender und mechanisch haftender Kontakte der Metallschicht mit dem Elementmetall in den Mesoporen;
j. Abheben der Metallschicht und der mesoporösen, in den Mesoporen teilweise mit Elementmetall befüllten, monokristallinen, (100)-orientierten Siliziumschicht unter mechanischem Zerstören der mikroporösen Ablöseschicht.

2. Verfahren nach Anspruch 1, **dadurch gekennzeichnet, dass** der monokristalline Silizium-Wafer p-dotiert ist und einen spezifischen Widerstand von weniger als 10 mΩcm, bevorzugt um 8 mΩcm, aufweist.

3. Verfahren nach einem der vorangehenden Ansprüche, dass die Mesoporen mit Porentiefen zwischen 4 und 16, bevorzugt zwischen 6 und 12 Mikrometer, geätzt werden.

4. Verfahren nach einem der vorangehenden Ansprüche, dass die Porosität der mesoporösen Schicht zwischen 70 % und 75 % eingerichtet wird.

5. Verfahren nach einem der vorangehenden Ansprüche, **dadurch gekennzeichnet, dass** in die Mesoporen eines der Elementmetalle Kupfer oder Nickel abgeschieden wird.

6. Verfahren nach Anspruch 5, **dadurch gekennzeichnet, dass** das Abscheiden des Elementmetalls in die Mesoporen bis in eine Porentiefe zwischen einigen 10 Nanometern und mehreren 100 Nanometern erfolgt.

7. Verfahren nach einem der vorangehenden Ansprüche, dass die wenigstens einige Mikrometer dicke Metallschicht aus einem anderen als dem in den Mesoporen abgeschiedenen Elementmetall gebildet wird.

8. Silizium-Anode für Sekundärbatterien **gekennzeichnet durch** eine Metallschicht und eine mesoporöse, in den Mesoporen teilweise mit Elementmetall befüllte, monokristalline, (100)-orientierte Siliziumschicht, wobei
- das Elementmetall in den Mesoporen in elektrisch leitendem und mechanisch haftendem Kontakt mit der Metallschicht steht
- die Mesoporen eine Porentiefe von wenigstens 4 Mikrometern aufweisen und
- die Mesoporen bis zu einer Porentiefe kleiner 2 Mikrometer mit Elementmetall befüllt werden.

9. Verwendung der Silizium-Anode nach Anspruch 8 als Anode in einer Sekundärbatterie mit einem Alkalimetall-Ionen enthaltenden Elektrolyten, wobei das Alkalimetall wenigstens eines aus der Gruppe Lithium, Natrium oder Kalium ist.

## Claims

1. A method for producing a silicon anode for secondary batteries, **characterised by** the steps of:
a. providing a monocrystalline silicon wafer with (100)-oriented flat faces;
b. contacting the rear side of the wafer with a flat first electrode;
c. introducing the front side of the wafer into an etching bath having a hydrofluoric acid-containing electrolyte and a second electrode;
d. electrochemically etching mesopores with a pore depth of at least 4 micrometres into the front side of the silicon wafer by establishing a predetermined etching current density while
e. generating a porosity of between 40% and 80% in the mesoporous layer;
f. generating a microporous release layer below the mesoporous layer by increasing the etching current density;
g. placing the etched wafer in an electroplating bath;
h. electrodepositing an elemental metal into the etched mesopores to a predetermined pore depth of less than 2 micrometres;
i. depositing a metal layer at least several micrometres thick onto the etched front side of the wafer while producing electrically conductive and mechanically adherent contacts of the metal layer with the elemental metal in the mesopores;
j. lifting off the metal layer and the mesoporous, monocrystalline, (100)-oriented silicon layer partially filled with elemental metal in the mesopores while mechanically destroying the microporous release layer.

2. A method according to claim 1, wherein the monocrystalline silicon wafer is p-doped and has a resistivity of less than 10 mΩcm, preferably around 8 mΩcm.

3. A method according to one of the preceding claims, wherein the mesopores are etched with pore depths of between 4 and 16, preferably between 6 and 12 micrometres.

4. A method according to any of the preceding claims, wherein the porosity of the mesoporous layer is between 70% and 75%.

5. A method according to one of the preceding claims, wherein one of the elemental metals copper or nickel is deposited into the mesopores.

6. A method according to claim 5, wherein the deposition of the elemental metal into the mesopores takes place to a pore depth of between a few tens of nanometres and several hundred nanometres.

7. A method according to any one of the preceding claims, wherein the metal layer, which is at least a few micrometres thick, is formed from a metal other than the elemental metal deposited in the mesopores.

8. Silicon anode for secondary batteries, **characterised by** a metal layer and a mesoporous, monocrystalline, (100)-oriented silicon layer partially filled with elemental metal in the mesopores, wherein
- the elemental metal in the mesopores is in electrically conduction and mechanically adhering contact with the metal layer
- the mesopores have a pore depth of at least 4 micrometres and
- the mesopores are filled with elemental metal up to a pore depth of less than 2 micrometres.

9. Use of the silicon anode according to claim 8 as an anode in a secondary battery having an electrolyte containing alkali metal ions, wherein the alkali metal is at least one from the group consisting of lithium, sodium or potassium.

## Revendications

1. Procédé de fabrication d'une anode en silicium pour batteries secondaires, **caractérisé par** les étapes suivantes :
a. fournir une plaquette de silicium monocristallin présentant des faces planes orientées (100);
b. mettre en contact la face arrière de la plaquette avec une première électrode plane;
c. introduire la face avant de la plaquette dans un bain de gravure contenant un électrolyte à base d'acide fluorhydrique et une deuxième électrode ;
d. graver par voie électrochimique des mésopores d'une profondeur d'au moins 4 micromètres dans la face avant de la plaquette de silicium en établissant une densité de courant de gravure prédéterminée tout en
e. générer une porosité comprise entre 40 % et 80 % dans la couche mésoporeuse ;
f. générer une couche de séparation microporeuse sous la couche mésoporeuse en augmentant la densité du courant de gravure ;
g. en plaçant la plaquette gravée dans un bain de galvanisation;
h. déposer par électrolyse un métal élémentaire dans les mésopores gravés jusqu'à une profondeur de pores prédéterminée inférieure à 2 micromètres ;
i. déposer une couche métallique d'au moins plusieurs micromètres d'épaisseur sur la face avant gravée de la plaquette tout en créant des contacts électriquement conducteurs et mécaniquement adhérents de la couche métallique avec le métal élémentaire présent dans les mésopores;
j. décoller la couche métallique et la couche de silicium mésoporeuse, monocristalline à orientation (100), partiellement remplie de métal élémentaire dans les mésopores, tout en détruisant mécaniquement la couche de séparation microporeuse.

2. Procédé selon la revendication 1, dans lequel la plaquette de silicium monocristallin est dopée de type p et présente une résistivité inférieure à 10 mΩcm, de préférence d'environ 8 mΩcm.

3. Procédé selon l'une des revendications précédentes, dans lequel les mésopores sont gravés avec des profondeurs de pores comprises entre 4 et 16, de préférence entre 6 et 12 micromètres.

4. Procédé selon l'une quelconque des revendications précédentes, dans lequel la porosité de la couche mésoporeuse est réglée entre 70 % et 75 %.

5. Procédé selon l'une des revendications précédentes, dans lequel l'un des métaux élémentaires, à savoir le cuivre ou le nickel, est déposé dans les mésopores.

6. Procédé selon la revendication 5, dans lequel le dépôt du métal élémentaire dans les mésopores s'effectue jusqu'à une profondeur de pores comprise entre quelques dizaines de nanomètres et plusieurs centaines de nanomètres.

7. Procédé selon l'une quelconque des revendications précédentes, dans lequel la couche métallique, qui a une épaisseur d'au moins quelques micromètres, est formée à partir d'un métal autre que le métal élémentaire déposé dans les mésopores.

8. Anode en silicium pour batteries secondaires, **caractérisée par** une couche métallique et une couche de silicium monocristallin mésoporeux à orientation (100), partiellement remplie de métal élémentaire dans les mésopores, dans laquelle
- le métal élémentaire présent dans les mésopores est en contact électriquement conducteur et mécaniquement
adhérent avec la couche métallique
- les mésopores ont une profondeur de pore d'au moins 4 micromètres et
- les mésopores sont remplis de métal élémentaire jusqu'à une profondeur de pore inférieure à 2 micromètres.

9. Utilisation de l'anode en silicium selon la revendication 8 en tant qu'anode dans une batterie secondaire comportant un électrolyte contenant des ions de métal alcalin, dans laquelle le métal alcalin est au moins un élément choisi parmi le groupe constitué du lithium, du sodium ou du potassium.
